# EUROPEAN PATENT SPECIFICATION

(11) **EP 2 706 827 B1**
(45) Date of publication and mention of the grant of the patent: **22.02.2017**
(21) Application number: 12183773.6
(22) Date of filing: 10.09.2012
(51) Int. Cl.: H05K 1/02, G02F 1/1343

(54) **Electrostatic discharge arrangement for an active matrix display**
Elektrostatische Entladungsanordnung für eine Aktivmatrixanzeige
Dispositif de décharge électrostatique pour affichage à matrice active

(43) Date of publication of application: 12.03.2014
(73) Proprietor: BlackBerry Limited, Waterloo, ON N2K 0A7 (CA)
(72) Inventor: Ho, Christopeher Ying Wai, Waterloo, Ontario, NL2 3W8 (CA); Wu, Ken, Waterloo, Ontario, NL2 3W8 (CA); Guo, Ming, Waterloo, Ontario, NL2 3W8 (CA)
(74) Representative: Noble, Nicholas

(56) References cited:
- EP-A1- 2 096 619
- US-A1- 2009 310 052
- US-B1- 6 241 537

## Description

### FIELD OF THE DISCLOSURE

The present disclosure generally relates to electronic displays, and more particularly to protecting circuitry of active matrix displays from electrostatic discharge.

### BACKGROUND

Electronic devices are prone to damage from Electrostatic Discharge (ESD). Mobile electronic devices are sometimes exposed to conditions that cause generation of electrostatic potentials that can cause ESD damage, particularly in miniaturized electronic components used in mobile devices. ESD is able to damage many electronic components of an electronic device including simple circuits, e.g. conductive traces within the device, and also complex logic circuits such as integrated circuit components.

As one example, a Liquid Crystal Display (LCD) is typically a relatively large component on an electronic device, particularly a mobile electronic device. An LCD typically includes relatively sensitive electronic components that are integrated into the display, such as Thin Film transistors (TFTs), driver integrated circuits (ICs), and transparent conductive traces to drive each pixel. The transparent conductive traces that drive each pixel are generally thin traces that are sometimes located close to one another.

As a large surface, the glass panel of the LCD is able to be parasitically coupled to other metals or conductors in the device such that electrostatic potentials will couple those conductors. An electrostatic potential generated on the glass panel of the LCD is able to generate an electrical current that can travel through the circuits on the Glass Panel, such as thin conductive traces, the driver IC, etc., that are able to damage to those components.

Therefore, the reliability of glass panel displays is limited by electrostatic potentials that are able to be generated on the glass panel and that are able to be discharged through components of the display.

US 2009/0310052 is directed to a liquid crystal display (LCD) panel including a first substrate, a second substrate, a liquid crystal layer, a sealant and an electrostatic protection structure. The first substrate and the second substrate are disposed in parallel. The sealant is for sealing the liquid crystal layer between the first substrate and the second substrate. The electrostatic protection structure is disposed within a non-display area outside the sealant. The electrostatic protection structure includes a first line disposed on the first substrate and surrounding the edge of the first substrate.

US 6,241,537 describes a connector assembly for a handheld computer. The connector assembly includes a plurality of conductive elements disposed on a first side of a printed circuit board housed with the handheld computer. One or more of the conductive elements has a pointed end.

EP 2096619 discloses an active matrix substrate defining a display region (D) which contributes to display and a frame region (F) which is arranged outside the display region (D) and does not contribute to display, the active matrix substrate comprising: a grounding wire extending along a circumference of the frame region (F) in the frame region (F), wherein a gate electrode line, part of which overlapping the grounding wire constitutes an electrostatic protection element, is arranged in part of the frame region (F) outside the grounding wire.

### SUMMARY

An invention is set out in the claims.

### BRIEF DESCRIPTION OF THE DRAWINGS

The accompanying figures where like reference numerals refer to identical or functionally similar elements throughout the separate views, and which together with the detailed description below are incorporated in and form part of the specification, serve to further illustrate various embodiments and to explain various principles and advantages all in accordance with the present disclosure, in which:
FIG. 1 illustrates a handheld electronic device in accordance with one example;
FIG. 2 illustrates a Liquid Crystal Display (LCD) layer side view, according to one example;
FIG. 3 illustrates a color filter glass top view, according to one example;
FIG. 4 illustrates an example spark gap point set region detail, according to one example;
FIG. 5 illustrates an electrostatic discharge structure formation process, according to one example; and
FIG. 6 is a block diagram of an electronic device and associated components in which the systems and methods disclosed herein may be implemented.

### DETAILED DESCRIPTION

As required, detailed embodiments are disclosed herein; however, it is to be understood that the disclosed embodiments are merely examples and that the systems and methods described below can be embodied in various forms. Therefore, specific structural and functional details disclosed herein are not to be interpreted as limiting, but merely as a basis for the claims and as a representative basis for teaching one skilled in the art to variously employ the disclosed subject matter in virtually any appropriately detailed structure and function. Further, the terms and phrases used herein are not intended to be limiting, but rather, to provide an understandable description.

The terms "a" or "an", as used herein, are defined as one or more than one. The term plurality, as used herein, is defined as two or more than two. The term another, as used herein, is defined as at least a second or more. The terms "including" and "having," as used herein, are defined as comprising (i.e., open language). The term "coupled," as used herein, is defined as "connected," although not necessarily directly, and not necessarily mechanically. The term "configured to" describes hardware, software or a combination of hardware and software that is adapted to, set up, arranged, built, composed, constructed, designed or that has any combination of these characteristics to carry out a given function. The term "adapted to" describes hardware, software or a combination of hardware and software that is capable of, able to accommodate, to make, or that is suitable to carry out a given function.

The following examples describe light transmissive electrostatic discharge structures that are incorporated on light transmissive panels. In the following description, the term light transmissive refers to substances or structures thought which transfer is able to be transferred. The term light transmissive, as used below, includes material that is transparent or translucent. In the following discussion, material that is described as light transmissive is able allow light to transfer through the material with or without distortion and with or without appreciable attenuation. Light transmissive material in some examples is further able to perform color filtering of light being transmitted through that material.

The below described systems and methods are described with reference to an example application that includes glass panel displays, such as a Liquid Crystal Display (LCD). As is understood for conventional LCDs, a liquid crystal display structure includes a number of pixels that are used to create an image to be displayed to a user. A color LCD generally divides each pixel into sub-pixels, where each pixel has a sub-pixel that emits or reflects light of a particular color for that pixel.

The display of one example consists of two glass layers sandwiching Liquid Crystal material. In one example, these two glass layers perform the functions of similar layers of a conventional LCD. In one example, the top glass layer in the display structure is a Color Filter (CF) glass that includes color filters used to provide color filtering of light that is emitted or reflected by each sub-pixel of the display. The bottom glass layer in one example is what is referred to as a Thin-Film Transistor (TFT) glass. The TFT glass layer of an LCD includes circuitry and electronic components used to drive the liquid crystal cells of each sub-pixel.

The color filter glass in this example has a layer of substantially transparent Indium Tin Oxide (ITO) material that is a light transmissive conductive material used to form a light transmissive conductive area that provides a common voltage, or VCOM, potential to one end of each liquid crystal cell of the display. In one example of a liquid crystal display with a common voltage, or VCOM, potential that is applied to one side of each liquid crystal cell by an electrical conductor held at the VCOM potential, the liquid crystal cells are controlled by an individualized voltage applied to an opposite side of each liquid crystal cell. In one example, a VCOM electrical potential is maintained on an electrically conductive structure, referred to herein as a VCOM layer, that extends across all liquid crystal cells of the liquid crystal display. As is understood by practitioners of ordinary skill in the relevant arts, ITO is a translucent material that appears to be substantially transparent when it is applied as a thin layer on a surface. As is further understood by practitioners of ordinary skill in the relevant arts, a VCOM layer consisting of a light transmissive layer of ITO that is maintained at a VCOM potential is formed on a side of a color filter glass of a liquid crystal device that is in contact with the liquid crystal cells. In an example described below, the VCOM ITO layer is formed so as to further provide an electrostatic potential discharge structure for the display structure. In further examples, light transmissive conductive material any electrically conductive material that allows light to pass through the material in any manner. In some examples, light transmissive conductive material includes different materials that are considered to be transparent or other materials that are considered translucent. Light transmissive conductive materials further include different electrically conductive materials that also exhibit various degrees of conductivity.

In one example, the layer of ITO transparent conductor on the color filter glass includes a number of spark gap geometrical features along its edge. These spark gap geometrical features in one example are located along the outer edge of the VCOM ITO layer. These spark gap geometrical features on the edge of the VCOM ITO layer are located in proximity to, but are conductively isolated from, an electrostatic discharge conductor that is maintained at an electrostatic discharge voltage potential, such as a system ground electrical potential. In one example, the spark gap geometrical features formed on the VCOM ITO layer are located in proximity to corresponding features on the electrostatic discharge conductor such that a spark gap is formed between the VCOM ITO layer and the electrostatic discharge conductor. The relative locations of the spark gap features of the VCOM ITO layer and the electrostatic discharge conductor are chosen so as to result in a breakdown voltage across the spark gap that occurs when the electrostatic potential between the VCOM ITO layer and the electrostatic discharge conductor exceeds a certain voltage. In one example, the features of the VCOM ITO layer and the electrostatic discharge conductor are configured such that an electrostatic breakdown and discharge occurs when the voltage between the VCOM ITO layer and the electrostatic discharge conductor exceeds a few hundred volts. This configuration causes the electrostatic discharge surge current to pass through to the electrostatic discharge conductor, which is able to be held at a ground potential, without damaging other circuits on display.

In this discussion, electrostatic breakdown refers to any transfer of electrons between or among two or more electrically conductive structures, where the transfer is caused by a breakdown of electrically insulating properties of materials or a vacuum that separates the two or more electrically conductive structures. In general, electrostatic breakdown occurs when the electrical voltage potential between two electrical conductors of a particular geometric configuration exceeds a discharge breakdown voltage. The discharge breakdown voltage of a particular pair of electrical conductors is dependent upon the physical configuration of those structures, particularly in the vicinity of their closest point. The discharge breakdown voltage is sometimes referred to as being a "determined voltage" because the discharge breakdown voltage is determined by the physical configuration of the two or more electrically conductive structures that are separated by an insulating material and by the conductive properties of the electrically conductive material in conjunction with the electrical properties of the insulating material separating them.

In one example, the electrostatic discharge conductor surrounds the VCOM ITO layer on the color filter glass. Advantages of this design include forming the electrostatic discharge conductor as part of the same ITO layer formation process that creates the VCOM ITO layer. The electrostatic discharge conductor in one example is maintained at a static discharge potential, which is a voltage potential to which electrostatic charges that build up in one or more parts of a device are discharged. In the case of a static discharge potential that is a system ground potential for the device, the electrostatic discharge conductor is simply routed to the electrical ground connection on display driver IC, to another ground location on the display, to any conductor that is held at ground potential, or to any combinations of these. As is generally understood, a "ground" potential of a device is an electrical potential used as a reference for other voltage potentials in the device and is not necessarily related to an "earth" potential of the physical earth in the vicinity of the device.

The design of one example allows the incorporation of these spark gap structures into the glass panel display using conventional manufacturing techniques without adding manufacturing complexity. The below described displays are able to be manufactured using conventional techniques and fabrication equipment, thereby resulting in a minimal cost impact. In one example, both the VCOM layer and the electrostatic discharge conductor are formed of light transmissive ITO material and are able to be deposited or otherwise placed on a glass layer by the same formation process. The manufacturing processes involved in forming ITO regions on a glass substrate allow economical fabrication of light transmissive conductive areas with high location tolerances that allow the formation of spark gap structures with highly precise and small dimensions. In one example, ITO fabrication techniques allow economical formation of ITO conductive areas with dimension tolerances of less than 1.5 µm. As is understood by practitioners of ordinary skill in the relevant arts, the term dimension tolerance generally refers to the accuracy with which components, such as edges of the ITO regions discussed above, are able to be located during a manufacturing process. In one example, the term dimension tolerance refers to the variation of actual location of a component in a manufactured product, such as the edge of the ITO region, relative to the location specified for that component by the design of the product. The economical formation of such precisely located conductors allows the economical fabrication of spark gap structures with narrow gaps and correspondingly low breakdown voltages as compared to metallic conductive trace fabrication techniques, which generally provide less precise trace location accuracies. Forming such small, precisely located spark gap structures along one or more edges of a transparent, conductive area on a display allows for precise control of the electrostatic voltage at which conduction across the spark gap breaks down and therefore the highest electrostatic potential that will be present on the transparent conductive area. In some examples, the electrostatic discharge conductor is formed of another conductive material, such as a metallic material, that is deposited in proximity to the transparent conductive area.

In the following discussion, components that are referred to as being "conductive" generally refer to components that are electrically conductive and are able to further have a reactive component. It is to be understood that different components having a wide range of conductivity, resistivity, inductance, or admittance, are encompassed within the term conductive. Conductive materials are further able to exhibit other forms of conductivity, such as heat conductivity. It is further understood that conductive materials are able to conduct "desired" electrical energy, such as signals or electrical power, as well as the undesired electrical energy, such as electrostatic discharge.

In one example, the spark gap structure formed along one or more edges of the VCOM conductive layer is within a hermetically sealed compartment inside of an LCD display. In such an example, any sparking that is present as a result of electrostatic discharge across the spark gaps is within the hermetically sealed compartment and will not be in contact with, for example, flammable gasses or other gasses present in the vicinity of the display.

Incorporating electrostatic discharge spark gap structures onto an edge of a transparent, conductive area of a transparent or translucent panel, such as a front panel of a display, provides an effective electrostatic field that is located in an area of a device that is likely to be in contact with electrostatic charge sources. One application of the below described electrostatic discharge structures is incorporating these structures into an LCD, including LCDs that further incorporate touch screen user interface functionality. Utilizing the already present VCOM transparent conductive layer as a conductive "screen" for an electrostatic discharge structure provides electrostatic protection across a relatively large area where a user is likely to touch the electronic device with a finger or conductive element. A user is at times likely to accumulate a relatively high static electric potential, particularly in conditions of low humidity. Electrostatic charge accumulated on a user is likely to couple, particularly through capacitive coupling, to the VCOM transparent conductive layer of an LCD display when the user touches the display as is common in many uses of a device with a display. Forming such an already present VCOM layer with additional features along one or more edges that function as spark gap elements and that are in proximity to an electrostatic discharge conductor allows the electrostatic potential that couples to the VCOM layer from a user or other source to be harmlessly dissipated without damaging internal components to which elements of the display are electrically coupled. Using the VCOM layer as an electrostatic shield for the display further operates to protect the active and passive components that are present throughout the display structure, such as the Thin Film Transistors (TFTs) that are located across the area of the display.

Adding electrostatic discharge features to a VCOM layer and forming an electrostatic discharge conductor in proximity to those additional features provides a cost effective electrostatic discharge structure that does not use additional components. Incorporating electrostatic discharge structures into already present layers of a display obviates the expense of including separate electrostatic discharge components into the device, simplifies manufacturing complexity and thereby improves manufacturing yields of such display devices. The lack of additional electrostatic discharge devices further obviates a need to increase the size of the display to accommodate the additional electrostatic devices. The effective electrostatic protection provided by the VCOM conductive layer, which generally extends over all liquid crystal cells of a display, also increase the reliability of devices incorporating such displays by protecting such devices from damage due to electrostatic discharge through sensitive components within the device.

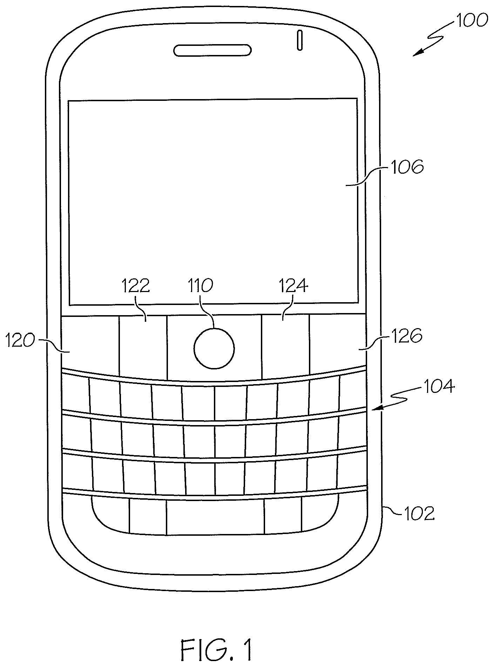

FIG. 1 illustrates a handheld electronic device 100 in accordance with one example. The portable electronic device 100 in this example is a handheld smartphone that supports cellular voice communications and also data communications with a central network. In one example, the electronic device 100 performs data communications with a wireless network to support accessing and exchanging data over the Internet. Data received by the electronic device is displayed on a display 106, which is able to be a color LCD device. In one example, the display 106 presents a graphical user interface for a user to access functions and to receive information. In some examples, the display 106 is a touch screen type display that allows a user to provide input to the device by touching one or more points on the display with, for example, a finger, stylus, other device, or combinations of such techniques. In some examples, a user is able to provide various inputs by also performing one or more gestures across the display 106, such as a swiping gesture.

The electronic device 100 is housed within a device case 102. The display 106 mounts on a surface of the device case 102. An alpha-numeric keyboard 104 is also physically coupled to the same surface of the device case 102 as the display 106. In various examples, the alpha-numeric keyboard 104 is able to be a QWERTY keyboard, a numeric telephone keypad, or any suitable user input device.

The device case 102 further includes a number of function keys. The illustrated device case 102 has a first function key 120, a second function key 122, a third function key 124, and a fourth function key 126. These function keys are able to be associated with a dedicated function, such as presenting an interface to initiate a voice call whenever pressed, or the function key is able to be associated with different functions based upon a current operating mode of the electronic device 100. The device case 102 further has a directional user input device 110, such as a joy stick or track pad.

The display 106 in one example includes an electrostatic discharge protection structure, as is described below. The display 106 in one example is a touchscreen input that allows a user to provide user interface inputs by touching areas of the display 106, by moving one or more fingers or objects across the display 106, or by other touchscreen input techniques. Although the illustrated electronic device 100 has an alpha-numeric keyboard 104 in addition to the display 106, further examples include electronic devices that do not have a large alpha-numeric keyboard 104 but include a larger display 106, which is able to include touch screen input functionality.

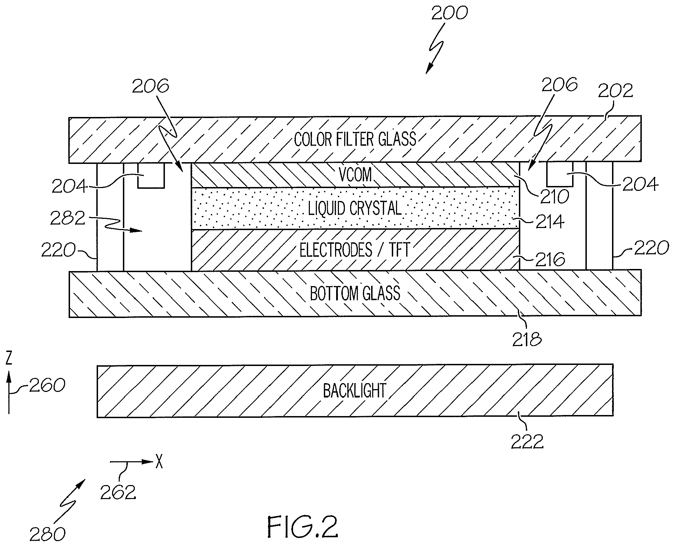

FIG. 2 illustrates a Liquid Crystal Display (LCD) layer side view 200, according to one example. The LCD layer side view 200 depicts several layers that are present in an LCD device 280. The LCD layer side view 200 depicts layers as they are stacked in the thickness of an LCD device 280 in a 'Z' direction 260. A 'Z' direction 260 is generally perpendicular to the display face of the LCD device 280, such as is shown for the electronic device 100. The LCD layer side view 200 shows each layer extending in a horizontal 'X' direction 264.

The LCD layer side view 200 depicts the structure of an example LCD structure that is similar to conventionally available LCD products. One example described below includes an LCD display that has a design that is similar to a conventional LCD product design except for the formation of a specially formed conductive layer on the bottom of the color filter glass 202. The use of a conventional LCD display design with a specially formed conductive layer allows incorporation of the below described electrostatic discharge structures into such LCD displays with minimal cost impact and with little specialized fabrication changes. Alternative examples are able to include other display designs that also include many aspects of conventional displays, or that differ further from such conventional designs. Further, a particular LCD device is able to include additional layers or is able to not include all of the layers depicted in the LCD layer side view 200. The layers depicted in the LCD layer side view 200 are presented to illustrate one example design of a display described herein. Alternative designs are able to be realized that are consistent with the disclosures herein.

The LCD layer side view 200 depicts a liquid crystal material layer 214 located in the middle of the LCD device 280. The liquid crystal material layer 214 includes an individual liquid crystal cell element for each sub-pixel of the LCD device 280. Each liquid crystal cell element of the liquid crystal material layer 214 is the portion of the liquid crystal material that corresponds to a particular sub-pixel of the liquid crystal display panel. The sub-pixels of each pixel in the LCD device 280 are described above in further detail with regards to the LCD display panel side view 200.

The individual liquid crystal cell elements of the liquid crystal material layer 214 are controlled by an electrode connected to a corresponding Thin Film Transistor (TFT) contained within the electrodes/thin film transistor (TFT) layer 216 that is deposited on a bottom glass layer 218. Each sub-pixel of an LCD device generally has one or more thin film transistors that control voltage applied to one end of each liquid crystal cell element within the liquid crystal material layer 214. As discussed below, a VCOM layer 210 is in contact with the other end of each liquid crystal cell element and is maintained at a common voltage, or VCOM. Applying different voltages to the liquid crystal material in each sub-pixel in the liquid crystal material layer 214 relative to the common voltage, or VCOM, changes the light transmission polarization properties of the liquid crystal material in that sub-pixel. In one example, the controller 230 controls each of the thin film transistors on the electrodes/TFT layer 216 to adjust the voltage applied to each sub-pixel on the liquid crystal material layer 214. Although the present discussion describes a conventional electrodes/TFT layer 216, liquid crystal cells are able to be constructed with different structures or designs to apply electrical potentials to individual liquid crystal cells, groups of liquid crystal cells, or both, relative to the VCOM potential in order to control their appearance.

The LCD layer side view 200 depicts a backlight 222. Backlight 222 includes light sources such as one or more Light Emitting Diodes (LEDs) or fluorescent light sources. Light generated by the backlight 222 and that passes through the bottom glass 218. The bottom glass 218 includes a bottom polarizer to cause light emitted through the top of the bottom glass 218 to have a single polarization. The light emitted through the top of the bottom glass 218 passes through the electrodes/TFT layer 216 and enters the bottom of the liquid crystal material 214. The polarization of light transmitted through each sub-pixel of the liquid crystal material layer 214 is able to be changed in varying amounts based upon the voltage applied to the liquid crystal material of that sub-pixel by the circuitry present on the electrodes/TFT layer 216.

The light exiting the top of the liquid crystal material layer 214 passes through the VCOM layer 210 and through to a color filter glass 202. In one example, the VCOM layer 210 is a transparent or light transmissive conductive area formed by depositing Indium Tin Oxide (ITO) on the bottom of the color filter glass 202. The VCOM layer 210 in one example is a continuous conductive area that is maintained at a common voltage (VCOM) and is a common electrode for each sub-pixel in the liquid crystal material layer 214. The polarization change of light passing through each sub-pixel of the liquid crystal material layer 214 is controlled by the voltage between the electrode connected to the TFT for that sub-pixel within the electrodes/TFT layer 216 and the VCOM layer 210.

In one example, an electrostatic discharge conductor 204 is formed in proximity to the VCOM layer 210 on the color filter glass 202. A gap 206 with a determined pattern separates the VCOM layer 210 from the electrostatic discharge conductor 204. As described in detail below, the determined pattern of the gap 206 forms at least one spark gap with a determined break down voltage. The design of the gap 206 between the electrostatic discharge conductor 204 and the VCOM layer 210 discharges electrostatic charge potentials that exceed the determined break down voltage. In one example, the electrostatic discharge conductor is formed with a pattern of deposited ITO pattern. In other examples, the electrostatic discharge conductor is able to be formed by any transparent, translucent, or opaque conductive material. An example pattern of a VCOM layer 210 and electrostatic discharge conductor 204 that is deposited on the color filter glass 202 is described in detail below.

In one example, the color filter glass 202 with the VCOM layer 210 and the discharge conductor 204 form at least part of an electrostatic shielding panel. The electrostatic shielding panel of one example is a panel, generally defined in the illustrated example by the color filter glass 202, that includes a light transmissive conductive area defined by the VCOM layer 210 in this example. The light transmissive conductive area defined by the VCOM layer 210 provides an electrostatic shield that accumulates any electrostatic energy originating from above the color filter glass 202 or otherwise generated on the VCOM layer 210, and inhibits the transfer of that electrostatic energy to elements below the VCOM layer, such as electrically sensitive components of the electrodes/TFT layer 216. As described, electrostatic energy that accumulates on the VCOM layer 210 and discharges the energy to the discharge conductor 202 prior to the electrical potential on the VCOM layer 210 rising to a level that is able to damage other components. The electrostatic shielding panel also operates to protect other electrical components of a device to which it is mounted.

The color filter glass 202 includes a color filter pattern on a top glass layer of the color filter glass 202, where the color filter pattern coincides with the sub-pixel pattern of the liquid crystal material layer 214. The color filter glass in one example has a top polarizer located on its top and is typically oriented with a light transmission polarization that is perpendicular to the light transmission polarization of a bottom polarizer that is within the bottom glass 218 in one example. The variable amount of light polarization alteration provided for each sub-pixel by the liquid crystal material layer 214 allows varying amounts of light to pass through both the pixel. Each sub-pixel of each pixel is thereby able to emit an adjustable intensity of its color by varying the amount of light that passes through that sub-pixel.

The above described components of the LCD device 280 that are located between the color filter glass 202 and the bottom glass 218 are within a sealed compartment 282, or a sealed structure. The sealed compartment 282 in one example is formed by the seal 220 that joins the color filter glass 202 and the bottom glass 218. Enclosing the LCD display components in a sealed compartment protects those components from contamination. In an example where the VCOM layer 210 and the electrostatic discharge conductor 204 are patterned so as to create spark gaps to discharge electrostatic potentials, the enclosed structure operates to isolate any sparks generated during electrostatic discharge from external elements, such as volatile gases.

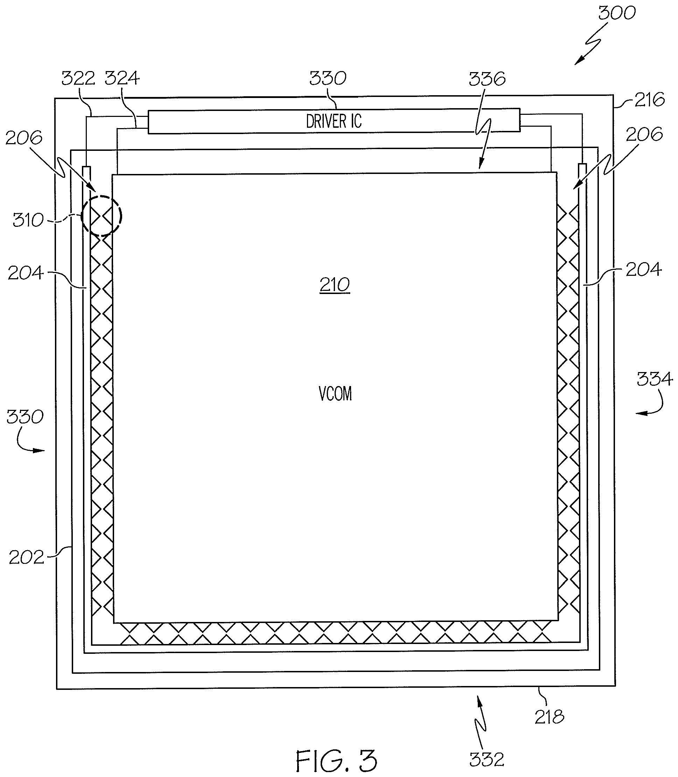

FIG. 3 illustrates a color filter glass top view 300, according to one example. The color filter glass top view 300 depicts an example pattern of a VCOM layer 210 that consists of ITO deposited on the underside of the color filter glass 202. The illustrated color filter glass 202 is an example of a transparent panel. As shown for this example, the VCOM layer 210 is an example of a light transmissive conductive area that in this example is a continuous area of ITO material that forms a generally square or rectangular region on the color filter glass 202. The VCOM layer 210 in this example extends across a substantial portion of a viewing area of the transparent panel. In this description, a light transmissive conductive area that extends over a substantial portion of a viewing area includes a light transmissive conductive area that covers a sufficient portion of a light transmissive panel so as to cause electrostatic voltage potentials accumulating in the viewing area of the light transmissive panel to couple to the light transmissive conductive area. In various examples, the light transmissive conductive area is able to extend across most of the viewing area but not reach the edges of the viewing area, or the light transmissvie conductive area substantially covering the viewing area is able to be perforated or otherwise not cover the entirety of the viewing area. In the illustrated example, the viewing area of the transparent panel corresponds to the pixels in the liquid crystal layer 214. In further examples, the viewing area of a light transmissive panel is an area through which light is transferred. The transfer of light through a viewing area is able to be for purposes of viewing images through the light transmissive panel, for conveying illumination through the light transmissive panel, or for any other purpose.

The VCOM layer 210 in the illustrated example extends over all of the pixels of the liquid crystal layer so as to from a Common Voltage (VCOM) potential along the top of each sub-pixel liquid crystal cell. An electrode/TFT glass 216 is also depicted as being below the color filter glass 202. As described above, the liquid crystal layer is sandwiched between the electrode/TFT glass 216 and the color filter glass 202. The liquid crystal layer is not depicted in the color filter glass top view 300 in order to more clearly depict aspects of the features being described.

The VCOM layer 210 is shown to have an outside perimeter with four edges, a left edge 330, a bottom edge 332, a right edge 334 and a top edge 336. An electrostatic discharge conductor 204 is located in proximity to part of the outside perimeter of the VCOM layer 210, specifically along the left edge 330, the bottom edge 332 and the right edge 334. As shown, the VCOM layer 210 is separated from and ohmically isolated from the electrostatic discharge conductor 204 by a gap 206. In this example, the VCOM layer 210 is also ohmically isolated from any other conductor that is at a static discharge potential. In the following discussion, two conductors are referred to as being ohmically isolated when an electrically conductive path does not exist between the two conductors. Ohmically isolated conductors are separated by normally insulating material, such as air, other non-conductive materials, active components, or combinations of these, such that electrons do not normally flow between the two conductors. It is to be understood, however, that ohmically isolated conductors are able to be electrically connected through, for example, active circuits such as power supplies in such a way that electrical signals are not normally conveyed betweent the ohmically isolated conductors. Ohmically isolated conductors, however, are able to be separated by material that allows a discharge of electrical potential by breaking down at a voltage such that an arc is formed that allows electrons to flow from one conductor to another. In general, two ohmically isolated conductors are able to be separated from one another in a manner that forms a spark gap within the insulating material, such as air, that is between the two conductors, where the dimensions of the spark gap and the characteristics of the insulating material result in a defined discharge breakdown voltage, which is the voltage between the two conductors at which a discharge of static electric charge occurs between the two conductors by an arc that forms across the insulating material.

In operation, the static electric potential that accumulates on the VCOM layer 210 is discharged across the gap 206, which consists of air or other insulating material, to the electrostatic discharge conductor 204. The electrostatic discharge conductor in this example is connected to a power supply connection that is at a static discharge potential, such as a system electrical ground potential or other voltage.

In various examples, a determined discharge breakdown voltage across the gap 206 is able to be set to various values based upon the conductivity and geometries of the VCOM layer 210, the electrostatic discharge conductor 204, and the material in the gap 206 (such as air, a vacuum, or other insulating material). In one example, one or both of the edges of the VCOM layer 210 and the electrostatic discharge conductor 204 are formed with geometric features that facilitate the discharge electrostatic accumulations across the gap 206. These geometric features are referred to herein as spark gap points. Although these geometric features are referred to as "points," these geometric features are generally able to be formed with any shape, such as curves or other geometric constructions, that do not necessarily create a sharp point. In various examples, the geometries of and spacing between conductive area spark gap points of the VCOM layer 210 and the discharge conductor 204 are able to be selected such that these conductors have an electrostatic breakdown voltage of less than 1000 volts. In other words, the electrostatic potential that is formed between the VCOM layer 210 and the electrostatic discharge conductor 204 in normal operations will not exceed 1000 volts because electrostatic potentials above that level will result in an electrostatic breakdown between those conductors and a discharge of the accumulated electrostatic potential. In further examples, the geometries of and spacing between conductive area spark gap points of the VCOM layer 210 and the discharge conductor 204 are able to be selected such that these conductors have an electrostatic breakdown voltage of, for example, less than 10,000 volts in one example, or less than 200 volts in another example. The precise light transmissive conductive layer formation that is available with ITO creation techniques allows the formation geometries of and spacing between conductive area spark gap points of the VCOM layer 210 and the discharge conductor 204 that support an electrostatic breakdown voltage of less than 200 volts.

In the illustrated example, a number of conductive area spark gap points are located along one side of the gap on the left edge 330, the bottom edge 332 and the right edge 334 of the VCOM layer 210. The electrostatic discharge conductor 204 that adjoins the left edge 330, the bottom edge 332 and the right edge 334 of the VCOM layer 210 also has corresponding discharge locations that consist of respective discharge spark gap points. In the illustrated example, each conductive area spark gap point has a respective discharge location, which includes a discharge spark gap point in this example, that is located in proximity to and across the gap 206 from each conductive area spark gap point of the VCOM layer 210. An example spark gap point set 310, which includes one conductive area spark gap point and one discharge spark gap point, is described in detail below. In the present discussion, a discharge location includes a location on any electrically conductive structure where electrostatic discharge to a second electrical conductor occurs to another conductor, where the other conductor is ohmically isolated from the electrically conductive structure with the discharge location. In general, two or more ohmically isolated electrically conductive structures that are configured to support electrostatic discharge between or among each other will each have their own discharge location, and a particular electrostatic discharge between two electrical conductors generally defines one discharge location on each of the electrical conductors.

The color filter glass top view 300 depicts a driver IC 320. The driver IC 320 in one example is incorporated into the LCD device 280. The driver IC 320 in one example generates control signals that drive each pixel and sub-pixel in the LCD device 280. The driver IC 320 generates signals that drive the TFTs of the electrodes/TFT layer 216, discussed above. Signals driving the rows and columns of sub-pixels in the LCD device 280 are not shown in this illustration in order to simplify aspects of the electrostatic discharge structure present in this example. In addition to driving each sub-pixel of the LCD device 280, the driver IC 320 generates a VCOM voltage level to be used as a potential for one end of each liquid crystal cell within the liquid crystal layer 214. In general, the driver IC 320 includes electrostatic protection circuits that protect components of the driver IC 320 from electrostatic potentials up to several thousand volts. The electrostatic discharge structures described herein that are incorporated into the VCOM layer 210 in one example are dimensioned to discharge electrostatic voltage potentials of several hundred volts. Discharging electrostatic potentials on the VCOM layer 210 of several hundred volts operates in conjunction with the electrostatic protection incorporated into the driver IC 320, and other devices coupled to the LCD device 280, to prevent damage due to electrostatic discharge.

The driver IC 320 in one example also includes one or more terminals that are at a static electric discharge voltage potential. In one example, the static electric discharge voltage potential is a system ground voltage potential. In further examples, the static electric discharge voltage potential is able to be any fixed or varying voltage potential relative to a system ground voltage potential. In general, the system ground voltage potential of a particular system is maintained by a power supply connection that is able to accept an amount of static electric charge that is expected to accumulate on the VCOM layer 210 of the particular system. In various examples, a "ground voltage potential" is not related to an actual "earth" electrical potential. In an example of a portable, battery operated electrical device, a ground voltage potential is an electrical potential that serves as a reference for other power supply voltages, signal voltages, and other voltages. In such a portable, battery powered device, the ground voltage potential of that device is not electrically coupled to an earth ground potential, and in fact the ground voltage potential of the battery powered device is able to vary relative to the earth ground potential in the vicinity of the device.

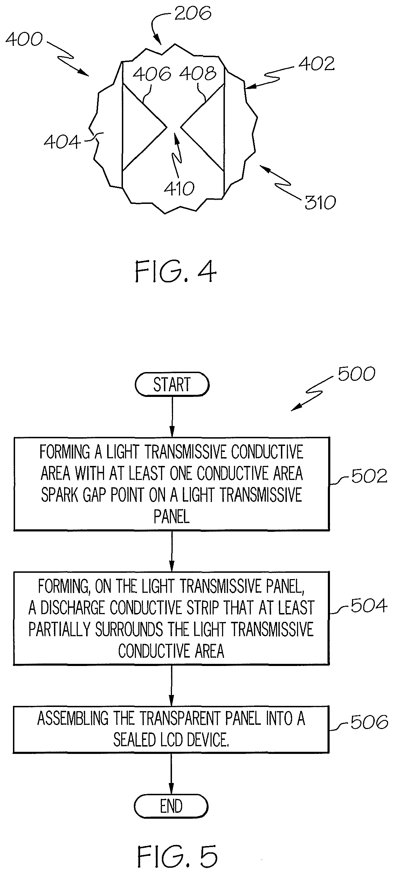

FIG. 4 illustrates an example spark gap point set region detail 400, according to one example. The spark gap region detail 400 depicts an expanded view of the above described example spark gap point set 310. The example spark gap point set region detail 400 depicts a VCOM layer portion 402, which is an example of a portion of a light transmissive conductive layer, and a discharge conductor portion 404. A conductive area spark gap point 408 is illustrated as a pointed protrusion from the illustrated VCOM layer portion 402. Conductive area spark gap points in further examples are able have any configuration that is in proximity to a discharge conductor such that the geometry of the conductive area spark gap point and the discharge conductor support electrostatic breakdown at less than a determined voltage. A discharge spark gap point 406 is illustrated as a pointed protrusion from the discharge conductor portion 404. The discharge spark gap point 406 is an example of a discharge location of a discharge conductor 204. Discharge locations in further examples are able have any configuration that is in proximity to a conductive area spark gap point 408 such that the geometry of the discharge location and the spark gap point support electrostatic breakdown at less than a determined voltage.

The example spark gap point set region detail 400 illustrates that the example spark gap point set 310 includes a pair of spark gap points, i.e., the discharge spark gap point 406 and the conductive area spark gap point 408, extending from their respective surfaces into the gap 206. The discharge spark gap point 406 and the conductive area spark gap point 408 are constructed such that these two spark gap points are opposite one another and are located in proximity to each other such as to form a static electric discharge gap 410. In one example, the dimension of the static electric discharge gap 410, in combination with the geometry of the discharge spark gap point 406 and the conductive area spark gap point 408, supports electrostatic breakdown at less than a determined voltage between the discharge spark gap point 406 and the conductive area spark gap point 408.

FIG. 5 illustrates an electrostatic discharge structure formation process 500, according to one example. The electrostatic discharge structure formation process 500 is an example of part of a Liquid Crystal Display (LCD) manufacturing process that creates a VCOM layer 210 and an electrostatic discharge conductor 204 that include the above described spark gaps.

The electrostatic discharge structure formation process 500 beings by forming, at 502, a light transmissive conductive area with at least one conductive area spark gap point on a light transmissive panel. In the following description, the light transmissive panel is a transparent panel. In further examples, light transmissive panels are able to be translucent panels or panels the perform color filtering. The formation of the light transmissive conductive area in one example is a formation of a VCOM layer of a Liquid Crystal Display (LCD). In that example, the light transmissive conductive area is deposited on a color filter glass panel, such as is described above. In addition to the creation of a VCOM layer is as found in some conventional LCDs, the light transmissive conductive area in this example is formed with at least one conductive area spark gap point. As is discussed above with regards to FIG. 3, a light transmissive conductive area is able to be formed with a large number of conductive area spark gap points that are formed along one or more edges of the light transmissive conductive area. In one example, the light transmissive conductive area is formed by depositing on the color filter glass a layer of Indium Tin Oxide (ITO) material with a thickness able to conduct anticipated electrical currents encountered by one or both of LCD operations and discharge of electrostatic potential that is able to accumulate on the VCOM layer.

The electrostatic discharge structure formation process 500 continues in one example by forming, at 504, a discharge conductive strip that at least partially surrounds the light transmissive conductive area. In one example, the discharge conductive strip is conductively connected to one or more discharge spark gap points that are located in proximity to the conductive area spark gap points that are conductively coupled to the light transmissive conductive area formed above. In one example, the discharge conductive strip is formed with the one or more discharge spark gap points extending from an edge of the discharge conductive strip that is opposite the light transmissive conductive area.

Although the above description describes forming the light transmissive conductive area and then forming the discharge conductive strip, further examples are able to perform a similar process by changing the order of formation of these two structure, combining the formation of these two structures into a single action, dividing the formation of each of these structures into sub-segments of the process and interleaving these sub-segments, include any combination of these alternative techniques, or perform any technique able to create the conductive areas described above.

The electrostatic discharge structure formation process 500 continues by assembling, at 506, the transparent panel, which is a color filter glass in one example, into a sealed LCD device. In one example, the transparent panel is assembled into an LCD device with a cross section similar to that depicted in the LCD layer side view 200, described above. Referring to FIG. 2, the transparent panel, which in one example corresponds the color filter glass 202 of the LCD layer side view 200, is attached to a seal 220 that completely encircles the Liquid crystal cells of the display. The seal 220 is further attached to the bottom glass 218 in that example to enclose the spark gap points that are conductively coupled to the light transmissive conducive area and the discharge conductor in a sealed compartment. Enclosing the spark gaps formed on the VCOM layer of an LCD device provides the benefit of isolating sparks resulting from the discharge of static electric potential from flammable gasses or other material that would come into proximity of those spark gaps if they were not enclosed in a sealed compartment.

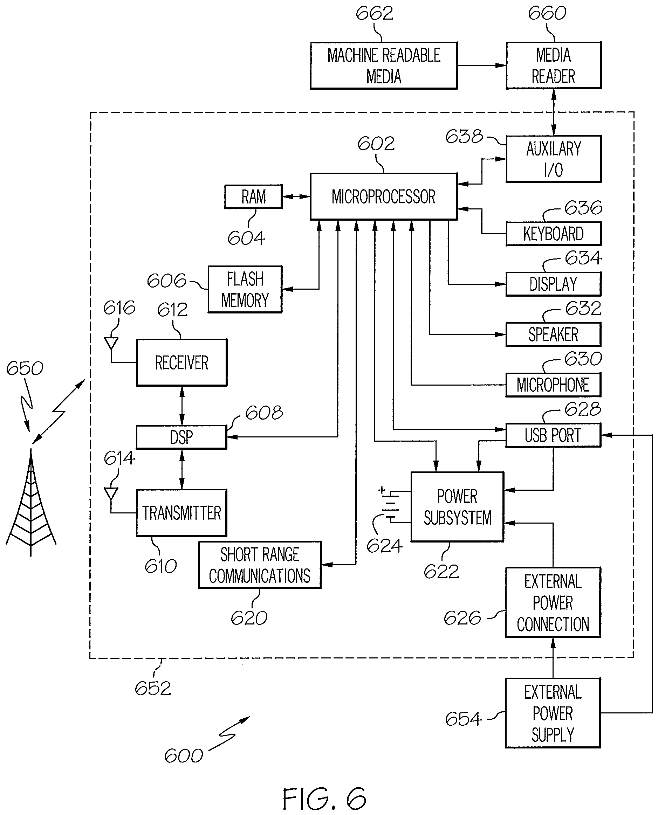

FIG. 6 is a block diagram of an electronic device and associated components 600 in which the systems and methods disclosed herein may be implemented. In this example, an electronic device 652 is a wireless two-way communication device with voice and data communication capabilities. Such electronic devices communicate with a wireless voice or data network 650 using a suitable wireless communications protocol. Wireless voice communications are performed using either an analog or digital wireless communication channel. Data communications allow the electronic device 652 to communicate with other computer systems via the Internet. Examples of electronic devices that are able to incorporate the above described systems and methods include, for example, a data messaging device, a two-way pager, a cellular telephone with data messaging capabilities, a wireless Internet appliance or a data communication device that may or may not include telephony capabilities. A particular example of such an electronic device is the electronic device 100, discussed above.

The illustrated electronic device 652 is an example electronic device that includes two-way wireless communications functions. Such electronic devices incorporate communication subsystem elements such as a wireless transmitter 610, a wireless receiver 612, and associated components such as one or more antenna elements 614 and 616. A digital signal processor (DSP) 608 performs processing to extract data from received wireless signals and to generate signals to be transmitted. The particular design of the communication subsystem is dependent upon the communication network and associated wireless communications protocols with which the device is intended to operate.

The electronic device 652 includes a microprocessor 602 that controls the overall operation of the electronic device 652. The microprocessor 602 interacts with the above described communications subsystem elements and also interacts with other device subsystems such as flash memory 606, random access memory (RAM) 604. The flash memory 606 and RAM 604 in one example contain program memory and data memory, respectively. The microprocessor 602 also interacts with an auxiliary input/output (I/O) device 638, a USB Port 628, a display 634, a keyboard 636, a speaker 632, a microphone 630, a short-range communications subsystem 620, a power subsystem 622, and any other device subsystems.

The display 634 in various examples is an LCD display that includes the above described electrostatic discharge structures. In various examples, the display 634 is able to be a display only component or is able to also include a touch screen user input capability.

A battery 624 is connected to a power subsystem 622 to provide power to the circuits of the electronic device 652. The power subsystem 622 includes power distribution circuitry for providing power to the electronic device 652 and also contains battery charging circuitry to manage recharging the battery 624. The power subsystem 622 includes a battery monitoring circuit that is operable to provide a status of one or more battery status indicators, such as remaining capacity, temperature, voltage, electrical current consumption, and the like, to various components of the electronic device 652.

The USB port 628 further provides data communication between the electronic device 652 and one or more external devices. Data communication through USB port 628 enables a user to set preferences through the external device or through a software application and extends the capabilities of the device by enabling information or software exchange through direct connections between the electronic device 652 and external data sources rather than via a wireless data communication network.

Operating system software used by the microprocessor 602 is stored in flash memory 606. Further examples are able to use a battery backed-up RAM or other non-volatile storage data elements to store operating systems, other executable programs, or both. The operating system software, device application software, or parts thereof, are able to be temporarily loaded into volatile data storage such as RAM 604. Data received via wireless communication signals or through wired communications are also able to be stored to RAM 604.

The microprocessor 602, in addition to its operating system functions, is able to execute software applications on the electronic device 652. A predetermined set of applications that control basic device operations, including at least data and voice communication applications, is able to be installed on the electronic device 652 during manufacture. Examples of applications that are able to be loaded onto the device may be a personal information manager (PIM) application having the ability to organize and manage data items relating to the device user, such as, but not limited to, e-mail, calendar events, voice mails, appointments, and task items. Further applications include applications that have input cells that receive data from a user.

Further applications may also be loaded onto the electronic device 652 through, for example, the wireless network 650, an auxiliary I/O device 638, USB port 628, short-range communications subsystem 620, or any combination of these interfaces. Such applications are then able to be installed by a user in the RAM 604 or a non-volatile store for execution by the microprocessor 602.

In a data communication mode, a received signal such as a text message or web page download is processed by the communication subsystem, including wireless receiver 612 and wireless transmitter 610, and communicated data is provided the microprocessor 602, which is able to further process the received data for output to the display 634, or alternatively, to an auxiliary I/O device 638 or the USB port 628. A user of the electronic device 652 may also compose data items, such as e-mail messages, using the keyboard 636, which is able to include a complete alphanumeric keyboard or a telephone-type keypad, in conjunction with the display 634 and possibly an auxiliary I/O device 638. Such composed items are then able to be transmitted over a communication network through the communication subsystem.

For voice communications, overall operation of the electronic device 652 is substantially similar, except that received signals are generally provided to a speaker 632 and signals for transmission are generally produced by a microphone 630. Alternative voice or audio I/O subsystems, such as a voice message recording subsystem, may also be implemented on the electronic device 652. Although voice or audio signal output is generally accomplished primarily through the speaker 632, the display 634 may also be used to provide an indication of the identity of a calling party, the duration of a voice call, or other voice call related information, for example.

Depending on conditions or statuses of the electronic device 652, one or more particular functions associated with a subsystem circuit may be disabled, or an entire subsystem circuit may be disabled. For example, if the battery temperature is low, then voice functions may be disabled, but data communications, such as e-mail, may still be enabled over the communication subsystem.

A short-range communications subsystem 620 is a further optional component which may provide for communication between the electronic device 652 and different systems or devices, which need not necessarily be similar devices. For example, the short-range communications subsystem 620 may include an infrared device and associated circuits and components or a Radio Frequency based communication module such as one supporting Bluetooth^{®} communications, to provide for communication with similarly-enabled systems and devices.

A media reader 660 is able to be connected to an auxiliary I/O device 638 to allow, for example, loading computer readable program code of a computer program product into the electronic device 652 for storage into flash memory 606. One example of a media reader 660 is an optical drive such as a CD/DVD drive, which may be used to store data to and read data from a computer readable medium or storage product such as computer readable storage media 662. Examples of suitable computer readable storage media include optical storage media such as a CD or DVD, magnetic media, or any other suitable data storage device. Media reader 660 is alternatively able to be connected to the electronic device through the USB port 628 or computer readable program code is alternatively able to be provided to the electronic device 652 through the wireless network 650.

### Information Processing System

The present subject matter can be realized in hardware, software, or a combination of hardware and software. A system can be realized in a centralized fashion in one computer system, or in a distributed fashion where different elements are spread across several interconnected computer systems. Any kind of computer system - or other apparatus adapted for carrying out the methods described herein - is suitable. A typical combination of hardware and software could be a general purpose computer system with a computer program that, when being loaded and executed, controls the computer system such that it carries out the methods described herein.

The present subject matter can also be embedded in a computer program product, which comprises all the features enabling the implementation of the methods described herein, and which - when loaded in a computer system - is able to carry out these methods. Computer program in the present context means any expression, in any language, code or notation, of a set of instructions intended to cause a system having an information processing capability to perform a particular function either directly or after either or both of the following a) conversion to another language, code or, notation; and b) reproduction in a different material form.

Each computer system may include, inter alia, one or more computers and at least a computer readable medium allowing a computer to read data, instructions, messages or message packets, and other computer readable information from the computer readable medium. The computer readable medium may include computer readable storage medium embodying non-volatile memory, such as read-only memory (ROM), flash memory, disk drive memory, CD-ROM, and other permanent storage. Additionally, a computer medium may include volatile storage such as RAM, buffers, cache memory, and network circuits. Furthermore, the computer readable medium may comprise computer readable information in a transitory state medium such as a network link and/or a network interface, including a wired network or a wireless network, that allow a computer to read such computer readable information.

Although specific embodiments of the subject matter have been disclosed, those having ordinary skill in the art will understand that changes can be made to the specific embodiments without departing from the spirit and scope of the disclosed subject matter. The scope of the disclosure is not to be restricted, therefore, to the specific embodiments, and it is intended that the appended claims cover any and all such applications, modifications, and embodiments within the scope of the present disclosure.

## Claims

1. An electrostatic shielding panel, comprising:
a light transmissive panel (202);
at least one discharge conductor (204);
a light transmissive conductive area (210) extending across the light transmissive panel, the light transmissive conductive area being ohmically isolated from the at least one discharge conductor (204), the light transmissive conductive area having an outside perimeter; and
a plurality of conductive area spark gap points (408), conductively coupled to the outside perimeter,
wherein each at least one discharge conductor has a plurality of discharge spark gap points (406), each discharge spark gap point corresponding to and being located in proximity to a respective one of the conductive area spark gap points so as to support electrostatic breakdown at less than a determined voltage between that discharge spark gap point (406) and the respective conductive area spark gap point.

2. The electrostatic shielding panel of claim 1, wherein the at least one discharge conductor comprises a light transmissive conductive material and has dimension tolerances of less than 1.5 µm.

3. The electrostatic shielding panel of claim 1, further comprising a sealed compartment (282),
wherein the conductive area spark gap points and the discharge spark gap points are disposed within the sealed compartment.

4. The electrostatic shielding panel of claim 3, wherein at least one side of the sealed compartment comprises the light transmissive panel.

5. The electrostatic shielding panel of claim 1, further comprising:
a liquid crystal display comprising a color filter glass (202), the color filter glass comprising the light transmissive panel, and
wherein the light transmissive conductive area is on the color filter glass.

6. The electrostatic shielding panel of claim 5,
wherein the liquid crystal display comprises an electrodes/thin film transistor layer (216) and a VCOM layer (210), and
wherein the VCOM layer comprises the light transmissive conductive area.

7. The electrostatic shielding panel of claim 1,
wherein the electrostatic shielding panel further comprises a discharge conductive strip (204), the discharge conductive strip comprising the at least one discharge conductor, the discharge conductive strip at least partially surrounding the light transmissive conductive area.

8. The electrostatic shielding panel of claim 7, wherein the discharge spark gap points and the conductive area spark gap points are located at respective locations relative to the discharge conductive strip such that the light transmissive conductive area has a discharge breakdown voltage of less than 1000 volts to the discharge conductive strip.

9. The electrostatic shielding panel of claim 7, wherein the discharge spark gap points and the conductive area spark gap points are located at respective locations relative to the discharge conductive strip such that the light transmissive conductive area has a discharge breakdown voltage of less than 200 volts to the discharge conductive strip.

10. A method of fabricating an electrostatic shielding panel, the method comprising:
forming, on a light transmissive panel (502), a light transmissive conductive area having a plurality of conductive area spark gap points; and
forming, on the light transmissive panel (502), at least one discharge conductor (504), each at least one discharge conductor having a plurality of discharge spark gap points, each discharge spark gap point corresponding to and being located in proximity to a respective one of the conductive area spark gap points so as to support electrostatic breakdown at less than a determined voltage between that discharge spark gap point and the respective conductive area spark gap point.

11. The method of claim 10, wherein the forming the light transmissive conductive area and forming the discharge conductor comprise forming the conductive area spark gap points at respective locations relative to the discharge spark gap points such that the light transmissive conductive area has a discharge breakdown voltage of less than 10,000 volts to the discharge conductor.

12. The method of claim 10, wherein the forming the light transmissive conductive area and forming the discharge conductor comprises forming the conductive area spark gap points at respective locations relative to the discharge spark gap points such that the light transmissive conductive area has a discharge breakdown voltage of less than 200 volts to the discharge conductor.

## Patentansprüche

1. Eine elektrostatische Abschirmungsplatte, die aufweist:
eine lichtdurchlässige Platte (202);
zumindest einen Entladungsleiter (204);
einen lichtdurchlässigen leitenden Bereich (210), der sich über die lichtdurchlässige Platte erstreckt, wobei der lichtdurchlässige leitende Bereich von dem zumindest einen Entladungsleiter (204) ohmisch isoliert ist, wobei der lichtdurchlässige leitende Bereich einen Außenumfang hat;
und
eine Vielzahl von "leitender Bereich"-Funkenstreckepunkten (408), die leitend mit dem Außenumfang gekoppelt sind,
wobei jeder zumindest eine Entladungsleiter eine Vielzahl von Entladungs-Funkenstreckepunkten (406) hat, wobei jeder Entladungs-Funkenstreckepunkt einem jeweiligen der "leitender Bereich"-Funkenstreckepunkte entspricht und sich in dessen Nähe befindet, um einen elektrostatischen Durchbruch bei weniger als einer bestimmten Spannung zwischen diesem Entladungs-Funkenstreckepunkt (406) und dem entsprechenden "leitender Bereich"-Funkenstreckepunkt zu unterstützen.

2. Die elektrostatische Abschirmungsplatte gemäß Anspruch 1, wobei der zumindest eine Entladungsleiter ein lichtdurchlässiges leitendes Material aufweist und Dimensionstoleranzen von weniger als 1,5 µm hat.

3. Die elektrostatische Abschirmungsplatte gemäß Anspruch 1, die weiter eine abgedichtete Kammer (282) aufweist,
wobei die "leitender Bereich"-Funkenstreckepunkte und die Entladungs-Funkenstreckepunkte in der abgedichteten Kammer angeordnet sind.

4. Die elektrostatische Abschirmungsplatte gemäß Anspruch 3, wobei zumindest eine Seite der abgedichteten Kammer die lichtdurchlässige Platte aufweist.

5. Die elektrostatische Abschirmungsplatte gemäß Anspruch 1, die weiter aufweist:
eine Flüssigkristallanzeige, die ein Farbfilterglas (202) aufweist, wobei das Farbfilterglas die lichtdurchlässige Platte aufweist, und
wobei der lichtdurchlässige leitende Bereich auf dem Farbfilterglas ist.

6. Die elektrostatische Abschirmungsplatte gemäß Anspruch 5,
wobei die Flüssigkristallanzeige eine Elektroden/Dünnschichttransistorschicht (216) und eine VCOM-Schicht (210) aufweist, und
wobei die VCOM-Schicht den lichtdurchlässigen leitenden Bereich aufweist.

7. Die elektrostatische Abschirmungsplatte gemäß Anspruch 1,
wobei die elektrostatische Abschirmungsplatte weiter einen leitenden Entladungsstreifen (204) aufweist, wobei der leitende Entladungsstreifen den zumindest einen Entladungsleiter aufweist, wobei der leitende Entladungsstreifen zumindest teilweise den lichtdurchlässigen leitenden Bereich umgibt.

8. Die elektrostatische Abschirmungsplatte gemäß Anspruch 7, wobei sich die Entladungs-Funkenstreckepunkte und die "leitender Bereich"-Funkenstreckepunkte an jeweiligen Positionen relativ zu dem leitenden Entladungsstreifen befinden derart, dass der lichtdurchlässige leitende Bereich eine Entladungsdurchbruchspannung von weniger als 1000 Volt zu dem leitenden Entladungsstreifen hat.

9. Die elektrostatische Abschirmungsplatte gemäß Anspruch 7, wobei sich die Entladungs-Funkenstreckepunkte und die "leitender Bereich"-Funkenstreckepunkte an jeweiligen Positionen relativ zu dem leitenden Entladungsstreifen befinden derart, dass der lichtdurchlässige leitende Bereich eine Entladungsdurchbruchspannung von weniger als 200 Volt zu dem leitenden Entladungsstreifen hat.

10. Ein Verfahren zur Herstellung einer elektrostatischen Abschirmungsplatte, wobei das Verfahren aufweist:
Bilden, auf einer lichtdurchlässigen Platte (502), eines lichtdurchlässigen leitenden Bereichs, der eine Vielzahl von "leitender Bereich"-Funkenstreckepunkten hat; und
Bilden, auf der lichtdurchlässigen Platte (502), zumindest eines Entladungsleiters (504), wobei jeder zumindest eine Entladungsleiter eine Vielzahl von Entladungs-Funkenstreckepunkten hat, wobei jeder Entladungs-Funkenstreckepunkt einem jeweiligen der "leitender Bereich"-Funkenstreckepunkte entspricht und sich in dessen Nähe befindet, um einen elektrostatischen Durchbruch bei weniger als einer bestimmten Spannung zwischen diesem Entladungs-Funkenstreckepunkt und dem jeweiligen "leitender Bereich"-Funkenstreckepunkt zu unterstützen.

11. Das Verfahren gemäß Anspruch 10, wobei das Bilden des lichtdurchlässigen leitenden Bereichs und das Bilden des Entladungsleiters aufweist ein Bilden der "leitender Bereich"-Funkenstreckepunkte an jeweiligen Positionen relativ zu den Entladungs-Funkenstreckepunkten derart, dass der lichtdurchlässige leitende Bereich eine Entladungsdurchbruchspannung von weniger als 10000 Volt zu dem Entladungsleiter hat.

12. Das Verfahren gemäß Anspruch 10, wobei das Bilden des lichtdurchlässigen leitenden Bereichs und das Bilden des Entladungsleiters aufweist ein Bilden der "leitender Bereich"-Funkenstreckepunkte an jeweiligen Positionen relativ zu den Entladungs-Funkenstreckepunkten derart, dass der lichtdurchlässige leitende Bereich eine Entladungsdurchbruchspannung von weniger als 200 Volt zu dem Entladungsleiter hat.

## Revendications

1. Panneau de blindage électrostatique, comprenant :
un panneau transmettant la lumière (202) ;
au moins un conducteur de décharge (204) ;
une zone conductrice transmettant la lumière (210) s'étendant à travers le panneau transmettant la lumière, la zone conductrice transmettant la lumière étant ohmiquement isolée de l'au moins un conducteur de décharge (204), la zone conductrice transmettant la lumière ayant un périmètre externe ; et
une pluralité de points d'éclateur de zone conductrice (408), couplés de manière conductrice au périmètre externe,
dans lequel chaque conducteur de décharge a une pluralité de points d'éclateur de décharge (406), chaque point d'éclateur de décharge correspondant à un point respectif des points d'éclateur de zone conductrice et étant situé à proximité de celui-ci de manière à supporter un claquage électrostatique à une tension inférieure à une tension déterminée entre ce point d'éclateur de décharge (406) et le point d'éclateur de zone conductrice respectif.

2. Panneau de blindage électrostatique de la revendication 1, dans lequel l'au moins un conducteur de décharge comprend un matériau conducteur transmettant la lumière et a des tolérances dimensionnelles inférieures à 1,5 µm.

3. Panneau de blindage électrostatique de la revendication 1, comprenant en outre un compartiment étanche (282),
dans lequel les points d'éclateur de zone conductrice et les points d'éclateur de décharge sont disposés dans le compartiment étanche.

4. Panneau de blindage électrostatique de la revendication 3, dans lequel au moins un côté du compartiment étanche comprend le panneau transmettant la lumière.

5. Panneau de blindage électrostatique de la revendication 1, comprenant en outre :
un dispositif d'affichage à cristaux liquides comprenant un verre de filtre de couleurs (202), le verre de filtre de couleurs comprenant le panneau transmettant la lumière, et
dans lequel la zone conductrice transmettant la lumière se trouve sur le verre de filtre de couleurs.

6. Panneau de blindage électrostatique de la revendication 5,
dans lequel le dispositif d'affichage à cristaux liquides comprend une couche d'électrodes/transistor à couche mince (216) et une couche VCOM (210), et
dans lequel la couche VCOM comprend la zone conductrice transmettant la lumière.

7. Panneau de blindage électrostatique de la revendication 1,
dans lequel le panneau de blindage électrostatique comprend en outre une bande conductrice de décharge (204), la bande conductrice de décharge comprenant l'au moins un conducteur de décharge, la bande conductrice de décharge entourant au moins partiellement la zone conductrice transmettant la lumière.

8. Panneau de blindage électrostatique de la revendication 7, dans lequel les points d'éclateur de décharge et les points d'éclateur de zone conductrice sont situés à des emplacements respectifs par rapport à la bande conductrice de décharge de sorte que la zone conductrice transmettant la lumière ait une tension de claquage par décharge inférieure à 1000 volts par rapport à la bande conductrice de décharge.

9. Panneau de blindage électrostatique de la revendication 7, dans lequel les points d'éclateur de décharge et les points d'éclateur de zone conductrice sont situés à des emplacements respectifs par rapport à la bande conductrice de décharge de sorte que la zone conductrice transmettant la lumière ait une tension de claquage par décharge inférieure à 200 volts par rapport à la bande conductrice de décharge.

10. Procédé de fabrication d'un panneau de blindage électrostatique, le procédé comprenant le fait :
de former, sur un panneau transmettant la lumière (502), une zone conductrice transmettant la lumière ayant une pluralité de points d'éclateur de zone conductrice ; et
de former, sur le panneau transmettant la lumière (502), au moins conducteur de décharge (504), chaque conducteur de décharge ayant une pluralité de points d'éclateur de décharge, chaque point d'éclateur de décharge correspondant à un point respectif des points d'éclateur de zone conductrice et étant situé à proximité de celui-ci de manière à supporter un claquage électrostatique à une tension inférieure à une tension déterminée entre ce point d'éclateur de décharge et le point d'éclateur de zone conductrice respectif.

11. Procédé de la revendication 10, dans lequel la formation de la zone conductrice transmettant la lumière et la formation du conducteur de décharge comprennent le fait de former les points d'éclateur de zone conductrice à des emplacements respectifs par rapport aux points d'éclateur de décharge de sorte que la zone conductrice transmettant la lumière ait une tension de claquage par décharge inférieure à 10000 volts par rapport au conducteur de décharge.

12. Procédé de la revendication 10, dans lequel la formation de la zone conductrice transmettant la lumière et la formation du conducteur de décharge comprennent le fait de former les points d'éclateur de zone conductrice à des emplacements respectifs par rapport aux points d'éclateur de décharge de sorte que la zone conductrice transmettant la lumière ait une tension de claquage par décharge inférieure à 200 volts par rapport au conducteur de décharge.
